(19) Europäisches Patentamt
European Patent Office
Office européen des brevets

(11) **EP 3 739 629 B1**

(12) **EUROPEAN PATENT SPECIFICATION**

(45) Date of publication and mention
of the grant of the patent:
**20.11.2024 Bulletin 2024/47**

(21) Application number: **20172844.1**

(22) Date of filing: **05.05.2020**

(51) International Patent Classification (IPC):
**H01L 27/12** (2006.01)  **H01L 21/84** (2006.01)
**H01L 29/786** (2006.01)

(52) Cooperative Patent Classification (CPC):
**H01L 21/84; H01L 27/1203; H01L 29/78648;
H01L 29/78654**

(54) **SEMICONDUCTOR STRUCTURE FOR FULLY DEPLETED SILICON-ON-INSULATOR (FDSOI)
TRANSISTOR**

HALBLEITERSTRUKTUR FÜR VOLLSTÄNDIG VERARMTEN
SILIZIUM-AUF-ISOLATOR(FDSOI)-TRANSISTOR

STRUCTURE SEMI-CONDUCTRICE POUR TRANSISTOR SILICIUM SUR ISOLANT
ENTIÈREMENT APPAUVRI (FDSOI)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.05.2019 US 201962846805 P
25.03.2020 US 202016829017**

(43) Date of publication of application:
**18.11.2020 Bulletin 2020/47**

(73) Proprietor: **MediaTek Singapore Pte. Ltd.
Singapore 138628 (SG)**

(72) Inventors:
• **KO, Jen-Wei
San Jose, California 95134 (US)**

• **ZENG, Zheng
San Jose, California 95134 (US)**
• **HUANG, Sheng-Yi
Hsinchu City 30078 (TW)**

(74) Representative: **Goddar, Heinz J.
Boehmert & Boehmert
Anwaltspartnerschaft mbB
Pettenkoferstrasse 22
80336 München (DE)**

(56) References cited:
**WO-A1-2012/161859     FR-A1- 3 007 577
US-A1- 2013 321 057     US-A1- 2018 159 471
US-B1- 6 562 666**

## Description

## BACKGROUND OF THE INVENTION

DESCRIPTION

### Field of the Invention

The invention relates to a semiconductor structure, and more particularly to a semiconductor structure including a fully depleted silicon-on-insulator (FDSOI) transistor.

### Description of the Related Art

Over the past few decades, the size of transistors has been continuously scaled down in order to increase performance and reduce power consumption, leading to better electronic devices that are able to do more useful, important, and valuable things faster, more clearly, and more efficiently.

Semiconductor-on-insulator (SOI) technology is an attractive candidate to push forward the frontiers imposed by Moore's law. Fully depleted SOI (FDSOI) techniques in particular may provide promising technologies that allow the fabrication of semiconductor devices at technology nodes of 28 nm and beyond. Aside from FDSOI techniques allowing the combination of high performance and low power consumption, complemented by an excellent responsiveness to power management design techniques, the fabrication processes employed in FDSOI techniques are comparatively simple and actually represent a low-risk evolution of conventional planar bulk CMOS techniques.

FR 3 007 577 Aldescribes a transistor having various levels of threshold voltages. US 2013 / 321 057 A1 describes a semiconductor structure including a transistor over a ground plane over an N-doped well, with STI regions on the side of the transistor structure, the STI regions separating landing areas for terminals formed in the well. Further prior art is described in WO 2012/161859 A1.

## BRIEF SUMMARY OF THE INVENTION

The invention is defined in the claims.

Semiconductor structures are provided for a fully depleted silicon-on-insulator (FDSOI) transistor. An embodiment of a semiconductor structure is provided. The semiconductor structure comprises a semiconductor substrate; a floating N-type well region (120) over the semiconductor substrate (110); an undoped layer (125a, 125b) over the semiconductor substrate (110) and in contact with the N-type well region (120) wherein the undoped layer (125a, 125b) is not doped with impurities or is a light doping P-well region; a fully depleted silicon-on-insulator, FDSOI, transistor (20) formed over the N-type well region (120), comprising: a buried oxide layer (210) over the N-type well region (120); a source region (220b) over the buried oxide layer (210); a drain region (220a) over the buried oxide layer (210); a silicon-on-insulator, SOI, layer (230) over the buried oxide layer (210) and between the source and drain regions (220a); and a metal gate (240) over the SOI layer (230); a first shallow trench isolation, STI, region (150b) over the undoped layer (125a, 125b); a first P-type doped region (140a) over the undoped layer (125a, 125b), wherein the first P-type doped region (140a) is separated from the drain region (220a) of the FDSOI transistor (20) by the first STI region (150b); and a first interconnection element (3 10a) over the first P-type doped region (140a) and configured to connect the first P-type doped region (140a) and the undoped layer to a ground.

A detailed description is given in the following embodiments with reference to the accompanying drawings. The embodiments described above and described herein below may be combined.

## BRIEF DESCRIPTION OF DRAWINGS

The invention can be more fully understood by reading the subsequent detailed description and examples with references made to the accompanying drawings, wherein:

FIG. 1 shows a cross-sectional view of a semiconductor structure according to an example which is not an embodiment of the invention.
FIG. 2 shows a cross-sectional view of a semiconductor structure according to an example which is not an embodiment of the invention.
FIG. 3 shows a cross-sectional view of a semiconductor structure according to an embodiment of the invention.
FIG. 4 shows a cross-sectional view of a semiconductor structure according to an embodiment of the invention.
FIG. 5 shows a cross-sectional view of a semiconductor structure according to an embodiment of the invention.

## DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

Some variations of the embodiments are described. Throughout the various views and illustrative embodiments, like reference numbers are used to designate like elements. It should be understood that additional operations can be provided before, during, and/or after a disclosed method, and some of the operations described can be replaced or eliminated for other embodiments of the method.

Furthermore, spatially relative terms, such as "beneath," "below," "lower," "above," "upper" and the like, may be used herein for ease of description to describe one element or feature's relationship to another element(s) or feature(s) as illustrated in the figures.

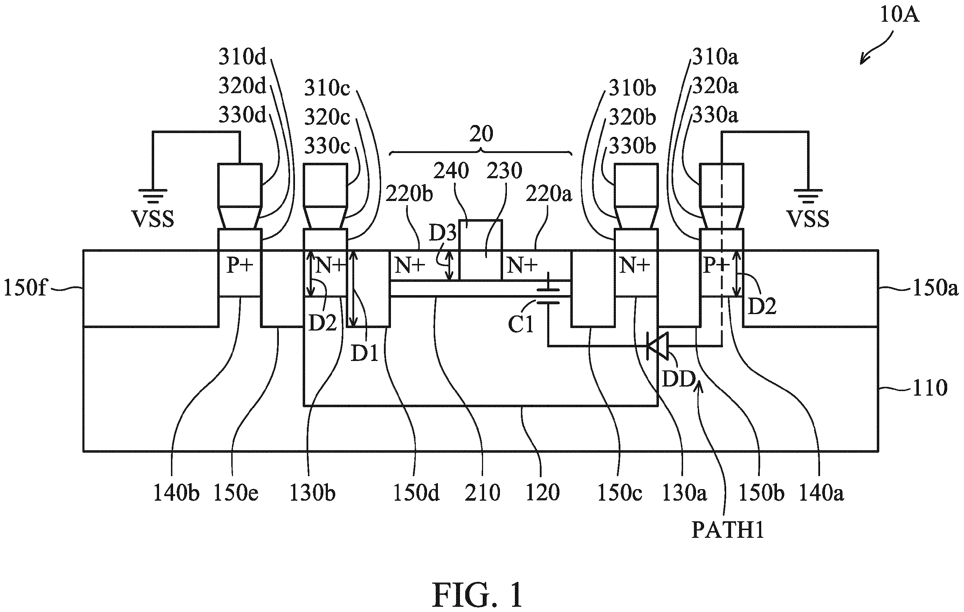

FIG. 1 shows a cross-sectional view of a semiconductor structure 10A according to an example, not falling under the scope of the claimed invention. An N-type well region 120 is formed on a semiconductor substrate 110. The semiconductor substrate 110 may be made of silicon or other semiconductor materials, and the semiconductor substrate 110 is a P-type substrate. A fully depleted silicon-on-insulator (FDSOI) transistor 20 is formed over the N-type well region 120. A buried oxide (BOX) layer 210 is formed over the N-type well region 120. In some embodiments, the BOX layer 210 may be formed of SiO2, SiN, or combination. The N-type doped regions 220a and 220b are formed over the BOX layer 210. A silicon-on-insulator (SOI) layer 230 is formed over the BOX layer 210 and between the N-type doped regions 220a and 220b. A metal gate 240 is formed over the SOI layer 230. The N-type doped regions 220a and 220b form the drain and source regions of the FDSOI transistor 20, respectively. Furthermore, a channel of the FDSOI transistor 20 is formed between the N-type doped regions 220a and 220b and below the metal gate 240. In order to simplify the description, other features of the FDSOI transistor 20, such as gate dielectric layer and so on, are omitted. In some embodiments, a heavy doping N-type well region is formed between the N-type well region 120 and the semiconductor substrate 110.

In FIG. 1, the N-type doped regions 130a and 130b are formed over the N-type well region 120. The N-type doped region 130a is separated from the N-type doped region 220a (i.e., the drain region of the FDSOI transistor 20) by a shallow trench isolation (STI) region 150c, and the N-type doped region 130b is separated from the N-type doped region 220b (i.e., the source region of the FDSOI transistor 20) by a STI region 150d. The STI regions 150c and 150d are formed over the N-type well region 120. The N-type doped regions 130a and 130b are the pick-up regions for the N-type well region 120. The depth D1 of the STI regions 150c and 150d is greater than the depth D2 of the N-type doped regions 130a and 130b. Furthermore, the depth D2 of the N-type doped regions 130a and 130b is greater than the depth D3 of the N-type doped regions 220a and 220b.

The STI regions 150a and 150b and the P-type doped region 140a are formed over the semiconductor substrate 110. In some embodiments, a P-type well region (not shown) is formed over the semiconductor substrate 110, and the STI regions 150a and 150b and the P-type doped region 140a are formed over the P-type well region on the right side of the N-type well region 120. The STI region 150b is in contact with the N-type well region 120 and the N-type doped region 130a. The P-type doped region 140a is separated from the N-type doped region 130a by the STI region 150b, and the P-type doped region 140a is disposed between the STI regions 150a and 150b. The P-type doped region 140a has the same depth as the N-type doped region 130a, i.e., the depth D1. Similarly, the STI regions 150e and 150f and the P-type doped region 140b are formed over the semiconductor substrate 110. In some embodiments, a P-type well region (not shown) is formed over the semiconductor substrate 110, and the STI regions 150e and 150f and the P-type doped region 140b are formed over the P-type well region on the left side of the N-type well region 120. The STI region 150e is in contact with the N-type well region 120 and the N-type doped region 130b. The P-type doped region 140b is separated from the N-type doped region 130b by the STI region 150e, and the P-type doped region 140b is disposed between the STI regions 150e and 150f. The P-type doped region 140b has the same depth as the N-type doped region 130b, i.e., the depth D1. The P-type doped regions 140a and 140b are the pick-up regions for the semiconductor substrate 110.

In FIG. 1, a plurality of interconnect layers are formed over the N-type doped regions 130a and 130b, and the P-type doped regions 140a and 140b. The contacts 310a through 310d are the interconnect elements of a first interconnect layer. For example, the contact 310a is formed on the P-type doped region 140a, the contact 310b is formed on the N-type doped region 130a, the contact 310c is formed on the N-type doped region 130b, and the contact 310d is formed on the P-type doped region 140b.

The vias 320a through 320d are the interconnect elements of a second interconnect layer over the first interconnect layer. For example, the via 320a is formed on the contact 310a, the via 320b is formed on the contact 310b, the via 320c is formed on the contact 310c, and the via 320d is formed on the contact 310d. Furthermore, the metals 330a through 330d are the interconnect elements of a third interconnect layer over the second interconnect layer. For example, the metal 330a is formed on the via 320a, the metal 330b is formed on the via 320b, the metal 330c is formed on the via 320c, and metal 330d is formed on the via 320d.

In the semiconductor structure 10A, a parasitic capacitor C1 is formed by the N-type doped region 220a, the BOX layer 210 and the N-type well region 120. In some embodiments, the parasitic capacitor C1 is adjacent to the STI region 150c. Furthermore, the semiconductor substrate 110 and the N-type well region 120 form a PN junction to operate as a parasitic diode DD. Therefore, a parasitic path PATH1 including the parasitic capacitor C1 and the parasitic diode DD is formed between the N-type well region 220a and the P-type well region 140a. In some embodiments, the parasitic diode DD is adjacent to the STI region 150b. Similarly, a parasitic capacitor (not shown) is formed by the N-type doped region 220b, the BOX layer 210 and the N-type well region 120. Furthermore, the semiconductor substrate 110 and the N-type well region 120 form a PN junction to operate as a parasitic diode (not shown) that is adjacent to the STI region 150e, thus another parasitic path (not shown) is formed between the N-type well region 220b and the P-type well region 310d. In order to simplify the description, only the path PATH1 is illustrated below.

In some embodiments, figure of merit (FOM) is an insertion loss for the FDSOI transistor 20 used as a switch. Furthermore, the FOM of the FDSOI transistor 20 is mainly obtained according to the following equation:

$$FOM \cong Ron \times Coff \, ,$$

where Ron represent the on-resistance of the FDSOI transistor 20, and Coff represent the parasitic capacitor of the FDSOI transistor 20. In some embodiments, the parasitic capacitor of the FDSOI transistor 20 is dominated from the drain capacitors of the FDSOI transistor 20. For the FDSOI transistor 20, the drain capacitors are parasitic capacitors. In some embodiments, the drain capacitors include a drain-gate capacitor Cdg, a drain-source capacitor Cds, and a drain-bulk capacitor Cdb. The capacitance value of the drain capacitors is mainly determined by the drain-bulk capacitor Cdb.

In FIG. 1, the anode of the parasitic diode DD is coupled to a ground VSS through the P-type doped region 140a, the contact 310a, the via 320a and the metal 330b. Thus, the parasitic diode DD will not be forward biased. Similarly, the P-type doped region 140b, the contact 310d, the via 320d and the metal 330d are coupled to the ground VSS. Furthermore, the N-type doped region 130a is floating, i.e., no signal or power line is connected to the metal 330b, the via 320b and the contact 310b. Similarly, the N-type doped region 130b is floating, i.e., no signal or power line is connected to the metal 330c, the via 320c and the contact 310c.

In the semiconductor structure 10A, because no signal is applied to the N-type well region 120 through the N-type doped regions 130a and 130b, the N-type well region 120 is floating. Thus, N-type doped region 130a is high impedance for the parasitic capacitor C1, and the parasitic capacitor C1 is coupled to the ground VSS through the parasitic diode DD, the P-type doped region 140a, the contact 310a, the via 320a and the metal 330a. In other words, the capacitor C1 and an equivalent capacitor of the parasitic diode DD are coupled in serial between the drain region of the FDSOI transistor 20 and the ground VSS. In general, capacitors coupled in series will reduce the capacitance of the capacitors coupled in series. Thus, the drain-bulk capacitor Cdb of the FDSOI transistor 20 is obtained by connecting the parasitic capacitor C1 and the equivalent capacitor of the parasitic diode DD in series, and the drain-bulk capacitor Cdb of the FDSOI transistor 20 has less capacitance than the parasitic capacitor C1. Therefore, the FDSOI transistor 20 of the semiconductor structure 10A has less FOM and less insertion loss.

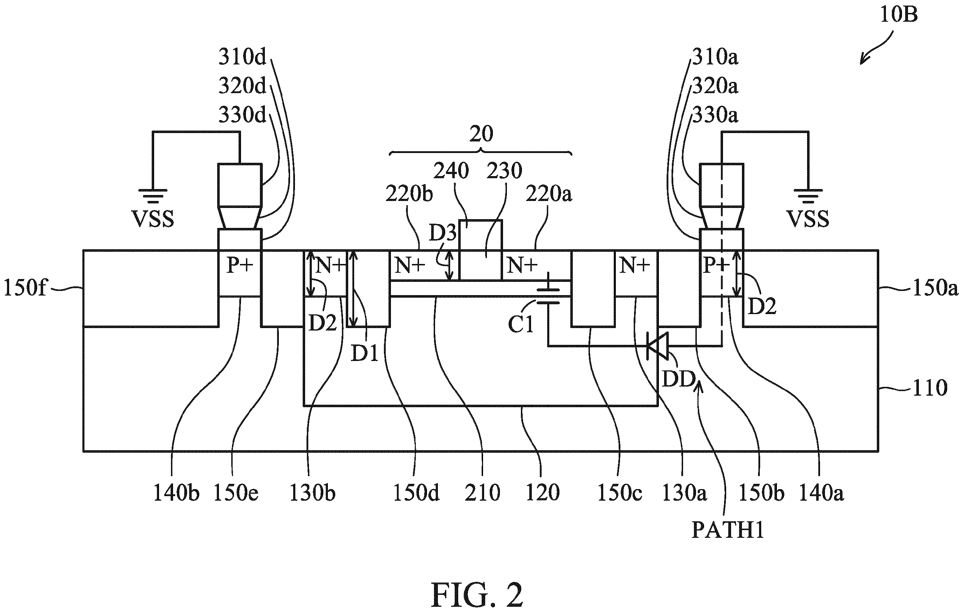

FIG. 2 shows a cross-sectional view of a semiconductor structure 10B according to an example, not falling under the scope of the claimed invention. The configuration of the semiconductor structure 10B is similar to the semiconductor structure 10A of FIG. 1, and the difference between the semiconductor structure 10A of FIG. 1 and the semiconductor structure 10B of FIG. 2 is that no interconnect elements (e.g., the contacts 310b and 310c, the vias 320b and 320c and the metals 330b and 330c of FIG. 1) are formed on the N-type doped regions 130a and 130b in the semiconductor structure 10B.

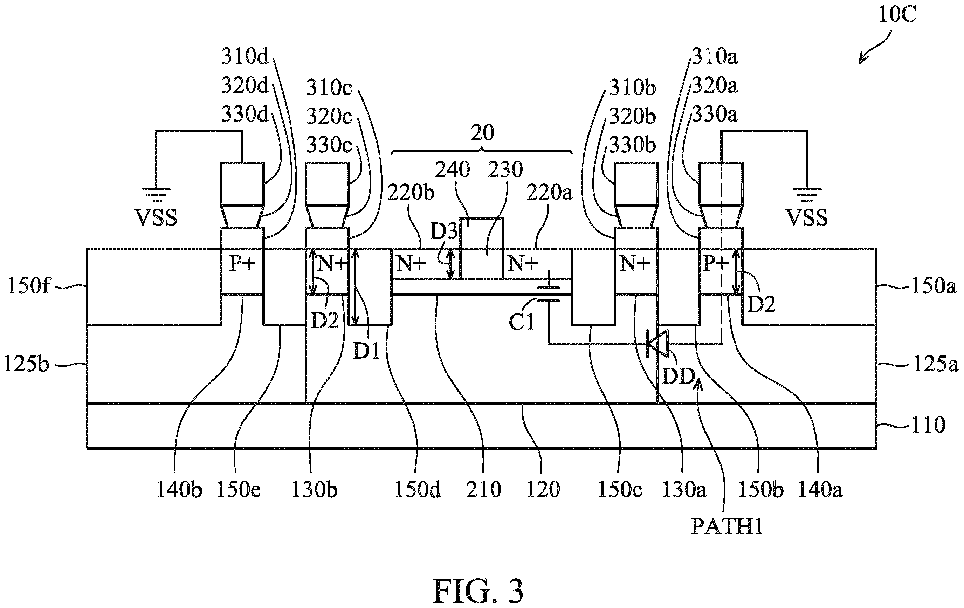

FIG. 3 shows a cross-sectional view of a semiconductor structure 10C according to an embodiment of the invention. The configuration of the semiconductor structure 10C is similar to the semiconductor structure 10A of FIG. 1, and the difference between the semiconductor structure 10A of FIG. 1 and the semiconductor structure 10C of FIG. 3 is that an undoped layer 125a/125b is formed over the semiconductor substrate 120 in FIG. 3. Furthermore, the STI regions 150a and 150b and the P-type doped region 140a are formed over a first region of the undoped layer 125a, and the STI regions 150d and 150e and the P-type doped region 140b are formed over the a second region of undoped layer 125b. The undoped layer 125a/125b is used to provide high isolation (or high impedance) for the parasitic capacitor C1. In some embodiments, the undoped layer 125a /125b is not doped with impurities. An equivalent capacitor of the first region the undoped layer 125a is coupled to the parasitic capacitor C1. Thus, the drain-bulk capacitor Cdb of the FDSOI transistor 20 has less capacitance than the parasitic capacitor C1. Therefore, the FDSOI transistor 20 of the semiconductor structure 10C has less FOM and less insertion loss.

In some embodiments, the undoped layer 125a/125b is a light doping P-type well region. Thus, the first region of the undoped layer 125a and the N-type well region 120 form a PN junction to operate as a parasitic diode DD. As described above, the capacitor C1 and an equivalent capacitor of the parasitic diode DD are coupled in serial between the drain region of the FDSOI transistor 20 and the ground VSS. In general, capacitors coupled in series will reduce the capacitance of the capacitors coupled in series. Thus, the drain-bulk capacitor Cdb of the FDSOI transistor 20 is obtained by connecting the parasitic capacitor C1 and an equivalent capacitor of the parasitic diode DD in series, and the drain-bulk capacitor Cdb of the FDSOI transistor 20 has less capacitance than the parasitic capacitor C1. Therefore, the FDSOI transistor 20 of the semiconductor structure 10C has less FOM and less insertion loss.

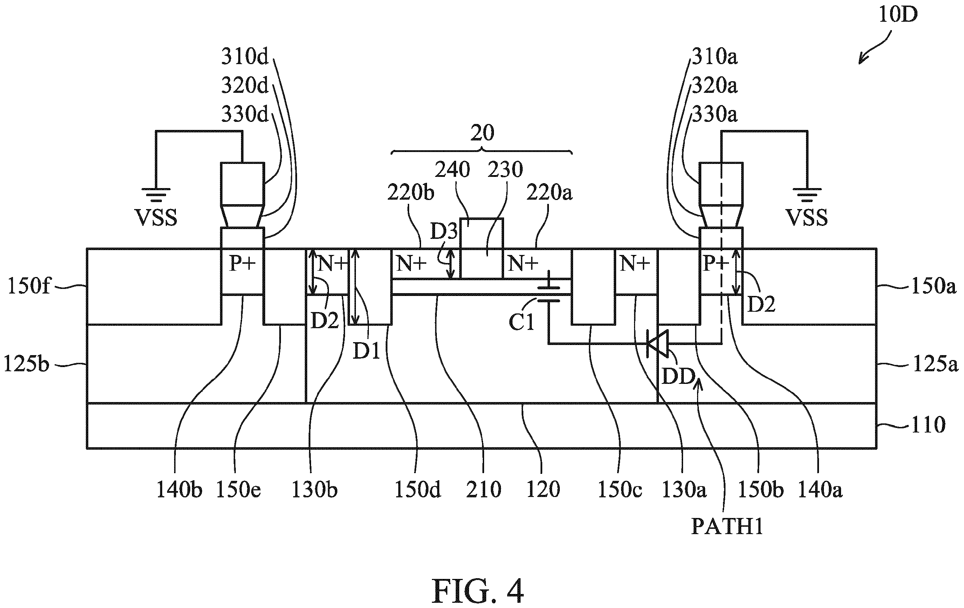

FIG. 4 shows a cross-sectional view of a semiconductor structure 10D according to an embodiment of the invention. The configuration of the semiconductor structure 10B is similar to the semiconductor structure 10C of FIG. 3, and the difference between the semiconductor structure 10C of FIG. 3 and the semiconductor structure 10D of FIG. 4 is that no interconnect elements (e.g., the contacts 310b and 310c, the vias 320b and 320c and the metals 330b and 330c of FIG. 3) are formed on the N-type doped regions 130a and 130b in the semiconductor structure 10D.

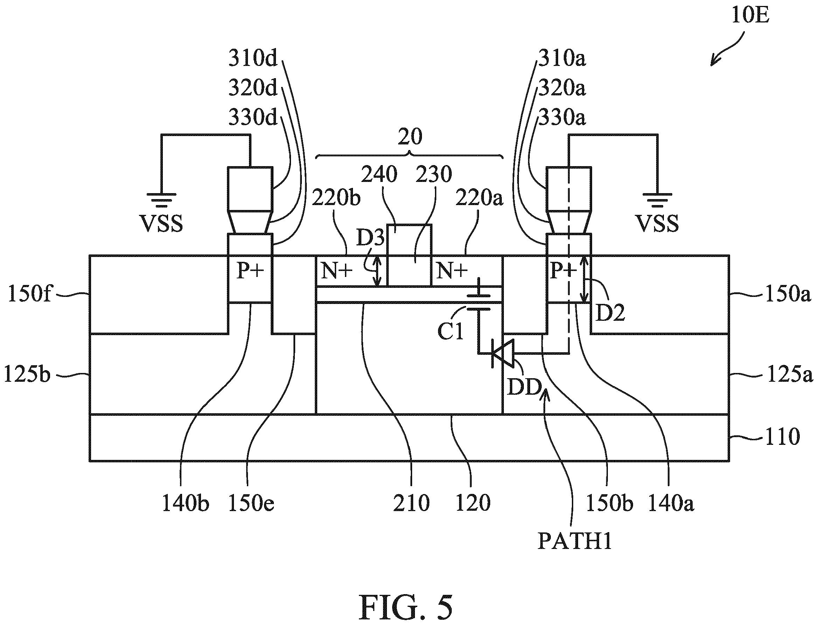

FIG. 5 shows a cross-sectional view of a semiconductor structure 10E according to an embodiment of the invention. The configuration of the semiconductor structure 10B is similar to the semiconductor structure 10C of FIG. 3, and the difference between the semiconductor structure 10C of FIG. 3 and the semiconductor structure 10E of FIG. 5 is that no pick-up regions for the N-type well region 120 is present in FIG. 5. Compared with the semiconductor structure 10C of FIG. 3, no STI regions 150c and 150d and no N-type doped regions 130a and 130b are formed over the N-type well region 120. Thus, the area of the N-type well region 120 is decreased in the semiconductor structure 10E, and the area of the FDSOI transistor 20 is also decreased. In the semiconductor structure 10E, the N-type doped region 220a (i.e., the drain region of the FDSOI transistor 20) is separated from the P-type doped region 140a by a STI region 150b, and the N-type doped region 220b (i.e., the source region of the FDSOI transistor 20) is separated from the P-type doped region 140b by a STI region 150e.

The undoped layer 125a/125b is formed over the semiconductor substrate 110, and the N-type well region 120 is formed over the semiconductor substrate 110 and between the first region of the undoped layer 125a and the second region of the undoped layer 125b. In some embodiments, the N-type well region 120 is surrounded by the undoped layer 125a/125b. Furthermore, the N-type well region 120 is contact with the undoped layer 125a/125b. As described above, the undoped layer 125a/125b is used to provide high isolation (or high impedance) for the parasitic capacitor C1. In some embodiments, the undoped layer 125a/125b is not doped with impurities. An equivalent capacitor of the first region of the undoped layer 125a is coupled to the parasitic capacitor C1. Thus, the drain-bulk capacitor Cdb of the FDSOI transistor 20 has less capacitance than the parasitic capacitor C1. Therefore, the FDSOI transistor 20 of the semiconductor structure 10C has less FOM and less insertion loss.

In FIG. 5, one side of the STI region 150b is in contact with the source region of the FDSOI transistor 20, the buried oxide layer 210 and the N-type well region 120. Furthermore, the opposite side of the STI region 150b is in contact with the P-type doped region 140a and the first region of the undoped layer 125a. Similarly, one side of the STI region 150e is in contact with the source region of the FDSOI transistor 20, the buried oxide layer 210 and the N-type well region 120, and the opposite side of the STI region 150e is in contact with the P-type doped region 140b and the second region of the undoped layer 125b.

Compared with the traditional transistors in the traditional RF switching circuit, the sources and drains of the FDSOI transistor (e.g., 20 of FIGs. 1-5) in a RF switching circuit do not need to be coupled to the ground through a resistor. In other words, no resistor coupled to the ground is present in the RF switching circuit. Thus, area and cost of the RF switching circuit are decreased. Furthermore, insertion loss is decreased for RF signal to be received or to be transmitted. According to the embodiments, by floating the N-type well region 120 under the FDSOI transistors 20, the drain-bulk capacitor Cdb of the FDSOI transistor 20 is decreased. For the FDSOI transistor 20, the capacitance value of the drain capacitors is mainly determined by the drain-bulk capacitor Cdb. Therefore, the FDSOI transistor 20 has less FOM and less insertion loss. Furthermore, by using the undoped layer 125a/125b, the pick-up regions of the N-type well region 120 can be removed. Thus, the area of the FDSOI transistor 20 is decreased.

## Claims

1. A semiconductor structure (10A-E), comprising:

　　a semiconductor substrate (110);
　　a floating N-type well region (120) over the semiconductor substrate (110);
　　an undoped layer (125a, 125b) over the semiconductor substrate (110) and in contact with the N-type well region (120) wherein the undoped layer (125a, 125b) is not doped with impurities or is a light doping P-well region;
　　a fully depleted silicon-on-insulator, FDSOI, transistor (20) formed over the N-type well region (120), comprising:

　　　　a buried oxide layer (210) over the N-type well region (120);
　　　　a source region (220b) over the buried oxide layer (210);
　　　　a drain region (220a) over the buried oxide layer (210);
　　　　a silicon-on-insulator, SOI, layer (230) over the buried oxide layer (210) and between the source and drain regions (220a); and
　　　　a metal gate (240) over the SOI layer (230);

　　a first shallow trench isolation, STI, region (150b) over the undoped layer (125a, 125b);
　　a first P-type doped region (140a) over the undoped layer (125a, 125b), wherein the first P-type doped region (140a) is separated from the drain region (220a) of the FDSOI transistor (20) by the first STI region (150b); and
　　a first interconnection element (310a) over the first P-type doped region (140a) and configured to connect the first P-type doped region (140a) and the undoped layer to a ground.

**2.** The semiconductor structure (10A-E) as claimed in claim 1, wherein the first P-type doped region (140a) has a depth that is greater than that of the source and drain regions (220a); and/or wherein a depth of the first P-type doped region (140a) is less than that of the first STI region (150b).

**3.** The semiconductor structure (10A-E) as claimed in claim 1 or 2, further comprising:

a second STI region (150e) over the undoped layer (125a, 125b);
a second P-type doped region (140b) over the undoped layer (125a, 125b), wherein the second P-type doped region (140b) is separated from the source region (220b) of the FDSOI transistor (20) by the second STI region (150e); and
a second interconnection element (310d) over the second P-type doped region (140b) and configured to connect the second P-type doped region (140b) to the ground,
wherein the N-type well region (120) is surrounded by the undoped layer (125a, 125b).

**4.** The semiconductor structure (10A-E) as claimed in claim 3, further comprising:

a third STI region (150c) over the N-type well region (120); and
a first N-type doped region (130a) over the N-type well region (120) and between the first and third STI regions (150b, 150e),
wherein the first N-type doped region (130a) is separated from the drain region (220a) of the FDSOI transistor (20) by the third STI region (150c),
wherein no interconnection element is formed over the first N-type doped region (130a) so that the first N-type doped region (130a) and the N-type well region (120) are floating.

**5.** The semiconductor structure (10A-E) as claimed in claim 4, further comprising:

a fourth STI region (150d) over the N-type well region (120); and
a second N-type doped region (130b) over the N-type well region (120) and between the second and fourth STI regions (150d),
wherein the second N-type doped region (130b) is separated from the source region (220b) of the FDSOI transistor (20) by the fourth STI region (150d),
wherein no interconnection element is formed over the second N-type doped region (130b) so that the second N-type doped region (130b) is floating.

**6.** The semiconductor structure (10A-E) of one of claims 3 to 5, wherein

the N-type well region (120) is between a first region and a second region of the undoped layer (125a, 125b);
the first shallow STI region (150b) is over the first region of the undoped layer (125a, 125b);
the first P-type doped region (140a) is over the first region of the undoped layer (125a, 125b);
the second STI region (150e) is over the second region of the undoped layer (125a, 125b); and
the second P-type doped region (140b) is over the second region of the undoped layer (125a, 125b).

**7.** The semiconductor structure (10A-E) as claimed in claim 6, wherein the first region of the undoped layer (125a, 125b) is separated from the second region of the undoped layer (125a, 125b) by the N-type well region (120), and the N-type well region (120) is in contact with the first and second regions of the undoped layer (125a, 125b).

**8.** The semiconductor structure (10A-E) as claimed in claim 6 or 7, wherein a depth of the first and second P-type doped regions (140a, 140b) is greater than that of the source and drain regions (220a); and/or

wherein a depth of the first and second P-type doped regions (140a, 140b) is less than that of the first and second STI regions (150b); and/or wherein the first and second P-type doped regions (140a, 140b) are coupled to a ground.

**9.** The semiconductor structure (10A-E) as claimed in one of claims 6 to 8, wherein one side of the first STI region (150b) is in contact with the drain region (220a) of the FDSOI transistor (20), the buried oxide layer (210) and the N-type well region (120), and an opposite side of the first STI region (150c) is in contact with the first P-type doped region (140a) and the first region of the undoped layer (125a, 125b); or wherein one side of the second STI region (150e) is in contact with the source region (220b) of the FDSOI transistor (20), the buried oxide layer (210) and the N-type well region (120), and the opposite side of the second STI region (150e) is in contact with the second P-type doped region (140b) and the second region of the undoped layer (125a, 125b).

**Patentansprüche**

**1.** Halbleiterstruktur (10A-E), aufweisend:

ein Halbleitersubstrat (110);
einen schwebenden n-Wannenbereich (120) über dem Halbleitersubstrat (110);

eine undotierte Schicht (125a, 125b) über dem Halbleitersubstrat (110) und mit dem n-Wannenbereich (120) in Kontakt, wobei die undotierte Schicht (125a, 125b) nicht mit Fremdstoffen dotiert ist oder ein leicht dotierter p-Wannenbereich ist;

einen vollständig verarmten Silizium-auf-Isolator-Transistor (FDSOI-Transistor) (20), der über dem n-Wannenbereich (120) ausgebildet ist, aufweisend:

> eine vergrabene Oxidschicht (210) über dem n-Wannenbereich (120);
>
> einen Source-Bereich (220b) über der vergrabenen Oxidschicht (210);
>
> einen Drain-Bereich (220a) über der vergrabenen Oxidschicht (210);
>
> eine Silizium-auf-Isolator-Schicht (SOI-Schicht) (230) über der vergrabenen Oxidschicht (210) und zwischen dem Source- und dem Drain-Bereich (220a); und
>
> ein Metall-Gate (240) über der SOI-Schicht (230);
>
> einen ersten Flachgrabenisolationsbereich (STI-Bereich) (150b) über der undotierten Schicht (125a, 125b);
>
> einen ersten p-dotierten Bereich (140a) über der undotierten Schicht (125a, 125b), wobei der erste p-dotierte Bereich (140a) durch den ersten STI-Bereich (150b) von dem Drain-Bereich (220a) des FDSOI-Transistors (20) getrennt ist; und
>
> ein erstes Interconnect-Element (310a) über dem ersten p-dotierten Bereich (140a) und welches dazu eingerichtet ist, den ersten p-dotierten Bereich (140a) und die undotierte Schicht mit einer Masse zu verbinden.

2. Halbleiterstruktur (10A-E) nach Anspruch 1, wobei der erste p-dotierte Bereich (140a) eine Tiefe aufweist, die größer als jene des Source- und des Drain-Bereichs (220a) ist; und/oder wobei eine Tiefe des ersten p-dotierten Bereichs (140a) kleiner als jene des ersten STI-Bereichs (150b) ist.

3. Halbleiterstruktur (10A-E) nach Anspruch 1 oder 2, ferner aufweisend:

> einen zweiten STI-Bereich (150e) über der undotierten Schicht (125a, 125b);
>
> einen zweiten p-dotierten Bereich (140b) über der undotierten Schicht (125a, 125b), wobei der zweite p-dotierte Bereich (140b) durch den zweiten STI-Bereich (150e) von dem Source-Bereich (220b) des FDSOI-Transistors (20) getrennt ist; und

> ein zweites Interconnect-Element (310d) über dem zweiten p-dotierten Bereich (140b) und welches dazu eingerichtet ist, den zweiten p-dotierten Bereich (140b) mit der Masse zu verbinden,
>
> wobei der n-Wannenbereich (120) von der undotierten Schicht (125a, 125b) umgeben ist.

4. Halbleiterstruktur (10A-E) nach Anspruch 3, ferner aufweisend:

> einen dritten STI-Bereich (150c) über dem n-Wannenbereich (120); und
>
> einen ersten n-dotierten Bereich (130a) über dem n-Wannenbereich (120) und zwischen dem ersten und dem dritten STI-Bereich (150b, 150c),
>
> wobei der erste n-dotierte Bereich (130a) durch den dritten STI-Bereich (150c) von dem Drain-Bereich (220a) des FDSOI-Transistors (20) getrennt ist,
>
> wobei über dem ersten n-dotierten Bereich (130a) kein Interconnect-Element ausgebildet ist, so dass der erste n-dotierte Bereich (130a) und der n-Wannenbereich (120) schwebend sind.

5. Halbleiterstruktur (10A-E) nach Anspruch 4, ferner aufweisend:

> einen vierten STI-Bereich (150d) über dem n-Wannenbereich (120); und
>
> einen zweiten n-dotierten Bereich (130b) über dem n-Wannenbereich (120) und zwischen dem zweiten und dem vierten STI-Bereich (150d),
>
> wobei der zweite n-dotierte Bereich (130b) durch den vierten STI-Bereich (150d) von dem Source-Bereich (220b) des FDSOI-Transistors (20) getrennt ist,
>
> wobei über dem zweiten n-dotierten Bereich (130b) kein Interconnect-Element ausgebildet ist, so dass der zweite n-dotierte Bereich (130b) schwebend ist.

6. Halbleiterstruktur (10A-E) nach einem der Ansprüche 3 bis 5, wobei

> der n-Wannenbereich (120) zwischen einem ersten Bereich und einem zweiten Bereich der undotierten Schicht (125a, 125b) angeordnet ist;
>
> der erste flache STI-Bereich (150b) über dem ersten Bereich der undotierten Schicht (125a, 125b) angeordnet ist;
>
> der erste p-dotierte Bereich (140a) über dem ersten Bereich der undotierten Schicht (125a, 125b) angeordnet ist;
>
> der zweite STI-Bereich (150e) über dem zweiten Bereich der undotierten Schicht (125a, 125b) angeordnet ist; und

der zweite p-dotierte Bereich (140b) über dem zweiten Bereich der undotierten Schicht (125a, 125b) angeordnet ist.

7. Halbleiterstruktur (10A-E) nach Anspruch 6, wobei der erste Bereich der undotierten Schicht (125a, 125b) durch den n-Wannenbereich (120) von dem zweiten Bereich der undotierten Schicht (125a, 125b) getrennt ist und der n-Wannenbereich (120) mit dem ersten und dem zweiten Bereich der undotierten Schicht (125a, 125b) in Kontakt ist.

8. Halbleiterstruktur (10A-E) nach Anspruch 6 oder 7, wobei eine Tiefe des ersten und des zweiten p-dotierten Bereichs (140a, 140b) größer als jene des Source- und des Drain-Bereichs (220a) ist; und/oder

wobei eine Tiefe des ersten und des zweiten p-dotierten Bereichs (140a, 140b) kleiner als jene des ersten und des zweiten STI-Bereichs (150b) ist; und/oder
wobei der erste und der zweite p-dotierte Bereich (140a, 140b) mit einer Masse gekoppelt sind.

9. Halbleiterstruktur (10A-E) nach einem der Ansprüche 6 bis 8, wobei eine Seite des ersten STI-Bereichs (150b) mit dem Drain-Bereich (220a) des FDSOI-Transistors (20), der vergrabenen Oxidschicht (210) und dem n-Wannenbereich (120) in Kontakt ist und eine entgegengesetzte Seite des ersten STI-Bereichs (150b) mit dem ersten p-dotierten Bereich (140a) und dem ersten Bereich der undotierten Schicht (125a, 125b) in Kontakt ist; oder wobei eine Seite des zweiten STI-Bereichs (150e) mit dem Source-Bereich (220b) des FDSOI-Transistors (20), der vergrabenen Oxidschicht (210) und dem n-Wannenbereich (120) in Kontakt ist und die entgegengesetzte Seite des zweiten STI-Bereichs (150e) mit dem zweiten p-dotierten Bereich (140b) und dem zweiten Bereich der undotierten Schicht (125a, 125b) in Kontakt ist.

**Revendications**

1. Structure de semi-conducteur (10A-E), comprenant :

un substrat semi-conducteur (110) ;
une région de puits de type N flottante (120) sur le substrat semi-conducteur (110) ;
une couche non dopée (125a, 125b) sur le substrat semi-conducteur (110) et en contact avec la région de puits de type N (120) dans laquelle la couche non dopée (125a, 125b) n'est pas dopée avec des impuretés ou est une région de puits P à dopage léger ;
un transistor de silicium sur isolant totalement appauvri, FDSOI (20) formé sur la région de puits de type N (120), comprenant :

une couche d'oxyde enfouie (210) sur la région de puits de type N (120) ;
une région source (220b) sur la couche d'oxyde enfouie (210) ;
une région de drain (220a) sur la couche d'oxyde enfouie (210) ;
une couche de silicium sur isolant, SOI (230) sur la couche d'oxyde enfouie (210) et entre les régions de source et de drain (220a) ; et
une grille métallique (240) sur la couche SOI (230) ;
une première région d'isolation de tranchée superficielle, STI, (150b) sur la couche non dopée (125a, 125b) ;
une première région dopée de type P (140a) sur la couche non dopée (125a, 125b), la première région dopée de type P (140a) étant séparée de la région de drain (220a) du transistor FDSOI (20) par la première région STI (150b) ; et
un premier élément d'interconnexion (310a) sur la première région dopée de type P (140a) et configuré pour connecter la première région dopée de type P (140a) et la couche non dopée à une masse.

2. Structure semi-conductrice (10A-E) selon la revendication 1, dans laquelle la première région dopée de type P (140a) a une profondeur qui est supérieure à celle des régions de source et de drain (220a) ; et/ou dans laquelle une profondeur de la première région dopée de type P (140a) est inférieure à celle de la première région STI (150b).

3. Structure de boîtier à semi-conducteur (10A-E) selon la revendication 1 ou 2, comprenant en outre :

une deuxième région STI (150e) sur la couche non dopée (125a, 125b) ;
une deuxième région dopée de type P (140b) sur la couche non dopée (125a, 125b), la deuxième région dopée de type P (140b) étant séparée de la région source (220b) du transistor FDSOI (20) par la deuxième région STI (150e) ; et
un deuxième élément d'interconnexion (310d) sur la deuxième région dopée de type P (140b) et configuré pour connecter la deuxième région dopée de type P (140b) à la terre,
dans lequel la région de puits de type N (120) est entourée par la couche non dopée (125a, 125b).

**4.** Structure semi-conductrice (10A-E) selon la revendication 3, comprenant en outre :

une troisième région STI (150c) sur la région de puits de type N (120) ; et
une première région dopée de type N (130a) sur la région de puits de type N (120) et entre les première et troisième régions STI (150b, 150e), dans laquelle la première région dopée de type N (130a) est séparée de la région de drain (220a) du transistor FDSOI (20) par la troisième région STI (150c),
dans laquelle aucun élément d'interconnexion n'est formé sur la première région dopée de type N (130a) de sorte que la première région dopée de type N (130a) et la région de puits de type N (120) sont flottantes.

**5.** Structure semi-conductrice (10A-E) selon la revendication 4, comprenant en outre :

une quatrième région STI (150d) sur la région de puits de type N (120) ; et
une deuxième région dopée de type N (130b) sur la région de puits de type N (120) et entre les deuxième et quatrième régions STI (150d), la deuxième région dopée de type N (130b) étant séparée de la région source (220b) du transistor FDSOI (20) par la quatrième région STI (150d), dans lequel aucun élément d'interconnexion n'est formé sur la deuxième région dopée de type N (130b) de sorte que la deuxième région dopée de type N (130b) est flottante.

**6.** Structure semi-conductrice (10A-E) selon l'une des revendications 3 à 5, dans laquelle

la région de puits de type N (120) est située entre une première région et une deuxième région de la couche non dopée (125a, 125b) ;
la première région STI superficielle (150b) est située au-dessus de la première région de la couche non dopée (125a, 125b) ;
la première région dopée de type P (140a) est située au-dessus de la première région de la couche non dopée (125a, 125b) ;
la deuxième région STI (150e) est située au-dessus de la deuxième région de la couche non dopée (125a, 125b) ; et
la deuxième région dopée de type P (140b) est située au-dessus de la deuxième région de la couche non dopée (125a, 125b).

**7.** Structure semi-conductrice (10A-E) selon la revendication 6, dans laquelle la première région de la couche non dopée (125a, 125b) est séparée de la deuxième région de la couche non dopée (125a, 125b) par la région de puits de type N (120), et la région de puits de type N (120) est en contact avec les première et deuxième régions de la couche non dopée (125a, 125b).

**8.** Structure semi-conductrice (10A-E) selon la revendication 6 ou 7, dans laquelle une profondeur des première et deuxième régions dopées de type P (140a, 140b) est supérieure à celle des régions de source et de drain (220a) ; et/ou

dans laquelle une profondeur des première et deuxième régions dopées de type P (140a, 140b) est inférieure à celle des première et deuxième régions STI (150b) ; et/ou
dans laquelle les première et deuxième régions dopées de type P (140a, 140b) sont couplées à une masse.

**9.** Structure semi-conductrice (10A-E) selon l'une des revendications 6 à 8, dans laquelle un côté de la première région STI (150b) est en contact avec la région de drain (220a) du transistor FDSOI (20), la couche d'oxyde enfouie (210) et la région de puits de type N (120), et un côté opposé de la première région STI (150e) est en contact avec la première région dopée de type P (140a) et la première région de la couche non dopée (125a, 125b) ; ou dans laquelle un côté de la deuxième région STI (150e) est en contact avec la région de source (220b) du transistor FDSOI (20), la couche d'oxyde enfouie (210) et la région de puits de type N (120), et le côté opposé de la deuxième région STI (150e) est en contact avec la deuxième région dopée de type P (140b) et la deuxième région de la couche non dopée (125a, 125b).

FIG. 1

EP 3 739 629 B1

FIG. 2

FIG. 3

EP 3 739 629 B1

FIG. 4

EP 3 739 629 B1

FIG. 5

EP 3 739 629 B1

**EP 3 739 629 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 3007577
- US 2013321057 A1
- WO 2012161859 A1